# EUROPEAN PATENT SPECIFICATION

(11) **EP 0 757 117 B1**
(45) Date of publication and mention of the grant of the patent: **07.07.1999**
(21) Application number: 95305392.3
(22) Date of filing: 01.08.1995
(51) Int. Cl.: C23C 16/44, C30B 25/14

(54) **Method and apparatus for deposition of material on a semiconductor wafer**
Verfahren und Vorrichtung zur Materialabscheidung auf einer Halbleiterscheibe
Procédé et dispositif pour le dépôt de matière sur une plaquette semi-conductrice

(43) Date of publication of application: 05.02.1997
(73) Proprietor: MEMC Electronic Materials, Inc., St. Peters, Missouri 63376 (US)
(72) Inventor: Glaenzer, Richard H., St. Peters, Missouri 63376 (US)
(74) Representative: Eyles, Christopher Thomas

(56) References cited:
- EP-A- 0 305 195
- DE-A- 1 913 676
- US-A- 4 928 626

## Description

### Background of the Invention

This invention relates generally to chemical vapor deposition of material onto semiconductor wafers, and more particularly to a method and apparatus for improving thickness uniformity of a layer of material deposited on semiconductor wafers in a barrel type chemical vapor deposition reactor.

Chemical vapor deposition is a process by which a stable solid may be formed by decomposition of chemical vapors using heat, plasma, ultraviolet light or other energy sources. Chemical vapor deposition is widely employed in the production of semiconductor wafers to grow epitaxial layers on a surface of the wafers, as well as for the deposition of polysilicon on the wafers. Epitaxy is an important process in the semiconductor material industry for achieving the necessary electrical properties of the semiconductor material. For example, a lightly doped epitaxial layer grown over a heavily doped substrate permits a CMOS device to be optimized for latch up immunity as a result of low resistance of the substrate. Other advantages, such as precise control of the dopant concentration profile and freedom from oxygen are also achieved.

Epitaxial growth is almost universally carried out by chemical vapor deposition because it is the most flexible and cost efficient method for growing epitaxial layers on semiconductor material. Generally speaking, chemical vapor deposition involves introduction of volatile reactants (e.g., SiCl₄, SiHCl₃, SiH₂Cl₂ or SiH₄) with a carrier gas (usually hydrogen) in a reactor. Achieving the desired epitaxial growth on the semiconductor material is also temperature dependent. Depending upon which reactant is used, the temperature in the reactor may be from 950° C to 1250° C. The environment in which the deposition occurs must be clean with the oxygen content below 1 ppma.

In general, epitaxial growth can be divided into two regimes distinguished by the temperature and concentration of reactants. At high temperatures, the reaction at the surface of the wafer is so fast that the growth rate is determined by the transport of reactants to the surface. This is the transport limited regime where the gas flow pattern determines the thickness uniformity. In this regime, the throughput is high because the growth rate is high. In the other regime, at lower temperatures, the rate controlling factor of the deposit is determined by the reaction rate at the surface. This is the reaction rate or kinetic limited regime.

As discussed in US-4,928,626 chemical vapor deposition is carried out in reactors which either pass the reactants and carrier gas generally parallel to the face of the semiconductor wafers (horizontal or cylindrical reactors) or generally perpendicularly to the face of the wafers (vertical reactors). To achieve a high throughput, cylindrical or barrel reactors operated in the transport limited regime, are most commonly employed in the industry. A barrel reactor has silicon carbide coated, graphite susceptor which is generally in the form of a polygonal tube having walls in which there are generally vertically arranged, circular recesses for receiving semiconductor wafers. The reactants and carrier gas are introduced generally at the top of the reactor through two nozzles which direct streams of gas in generally horizontal directions. The mass flow rate of gas through each nozzle remains substantially constant throughout the deposition cycle of the barrel reactor. The streams of gas from each nozzle collide with each other and a wall of the reactor, and the gas flows generally downwardly and then up on the opposite side of the susceptor. The gas flow is made more complex by interaction of the gas with the walls of the reactor and the rotation of the susceptor in the reactor, but the flow of the gas is always substantially parallel to the faces of the wafers.

One of the primary problems associated with chemical vapor deposition in the transport limited regime in barrel reactors is maintaining the thickness uniformity of the deposited layer of material on each wafer and between the various wafers held on the susceptor. Thickness uniformity has become increasingly important as the line widths of integrated circuits are reduced. Narrow line widths of integrated circuits require very flat surfaces to accommodate the limited depth-of-field of optical lithography.

The most common methods of controlling thickness uniformity are to adjust the direction of the nozzles and to adjust the valves which control the flow rate of gas to each nozzle. Generally speaking, adjustment of the direction of the nozzles affects the thickness uniformity in a vertical direction along the wafers, and adjustment of the relative mass flow rates between the nozzles affects the thickness uniformity in horizontal directions. In addition, minor changes to achieve thickness uniformity can be made through temperature adjustments and altering the flow of carrier gas (H₂) through the nozzles and purge gas (H₂) through the susceptor. It is also known to reverse the direction of rotation of the susceptor half way through the deposition cycle of the barrel reactor to improve thickness uniformity.

### Summary of the Invention

Among the several objects and features of the present invention is the provision of a method for chemical vapor deposition of material on a semiconductor wafer which produces a high level of uniformity in the thickness of the layer of material deposited on the wafer, measured all around the wafer; the provision of such a method which can be carried using modified, but existing equipment.

Further among the several objects and features of the present invention may be noted the provision of a barrel reactor which carries out the method of the present invention; the provision of such a barrel reactor which alters mass flow rates during the deposition process to achieve greater thickness uniformity in the layer of material deposited on the wafers.

Other objects and features will be in part apparent and in part pointed out hereinafter.

### Brief Description of the Drawings

FIG. 1 is a schematic illustrating a piping arrangement for delivering gas to a barrel reactor;
FIG. 1A is a schematic illustrating another piping arrangement for delivering gas to the barrel reactor;
FIG. 2 is a schematic perspective of the barrel reactor illustrating additional elements of the reactor;
FIG. 3 is a schematic top plan showing operation of the barrel reactor during a first portion of a deposition cycle of the barrel reactor;
FIG. 4 is a schematic top plan showing operation of the barrel reactor during a second portion of the deposition cycle;
FIG. 5 is a graph showing top to bottom thickness variation of wafers processed in a prior art barrel reactor on a five sided susceptor holding wafers three high on each wall;
FIG. 6 is a graph showing right to left thickness variation of the wafers processed in the prior art barrel reactor;
FIG. 7 is a graph showing top to bottom thickness variation of wafers process in a barrel reactor and according to the method of the present invention on a five sided susceptor holding wafers three high on each wall;
FIG. 8 is a graph showing right to left thickness variation of the wafers processed in the barrel reactor and according to the method of the present invention;
FIG. 9A is a graph showing right to left thickness variation of wafers processed during a first half of a deposition cycle of the barrel reactor of the present invention;
FIG. 9B is a graph showing right to left thickness variation of wafers processed during a second half of the deposition cycle;
FIG. 10 is a plot illustrating methodology for an overall thickness uniformity measurement of wafers; and
FIG. 11 is a cumulative plot comparing overall thickness uniformity of wafers processed according to the present invention with those processed according to the prior art.

Corresponding reference characters indicate corresponding parts throughout the several views of the drawings.

### Detailed Description of the Preferred Embodiments

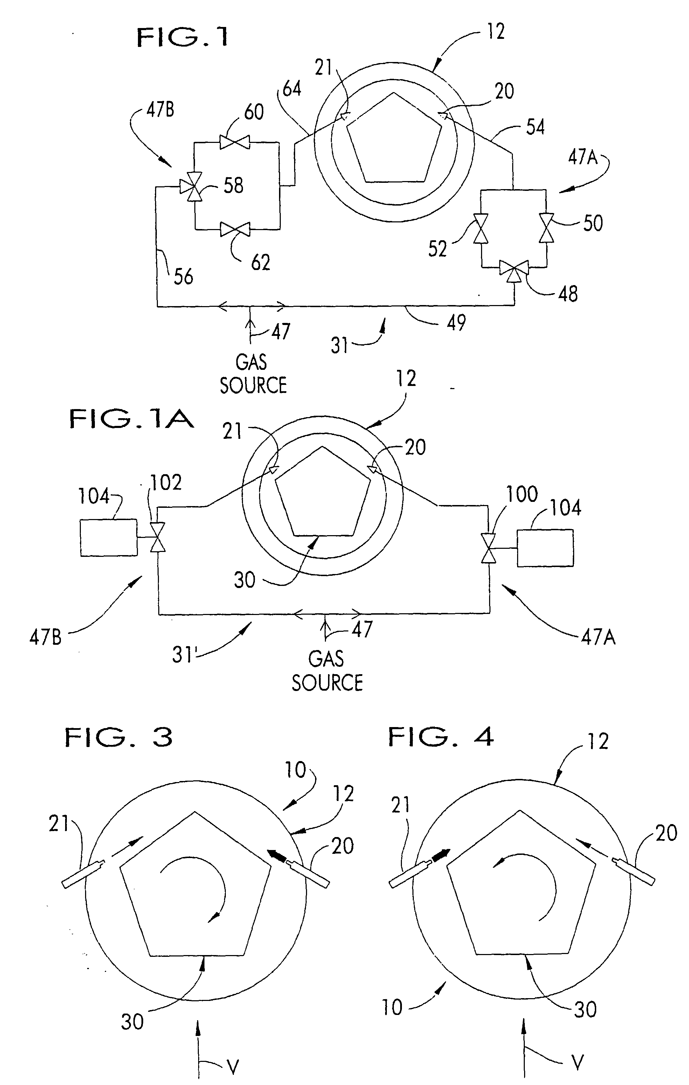

Referring now to the drawings and in particular to Figs. 1 and 2, a barrel reactor, for use in chemical vapor deposition of a layer of material on one face of wafers of semiconductor material, is generally indicated at 10. The barrel reactor includes a quartz bell jar 12 (in an inverted position) having an upper lip (not shown) secured between an annular baseplate 16 and a radially projecting flange 17 of a gas ring indicated generally at 18. The gas ring at least partially houses a first nozzle 20 and a second nozzle 21 for introduction of gas, including a reactant which is to be decomposed for deposition on the wafers and a carrier, into the bell jar 12. The gas is delivered through a delivery system, generally indicated at 31, to the nozzles 20, 21. The bell jar 12 is formed with an exhaust port (not shown) in its bottom through which spent gas is exhausted. A housing 24 containing the bell jar 12 also contains radiant heat lamps 26 and heat exchangers 28 for controlling the heat applied to the chamber of the bell jar.

A five sided, silicon carbide coated graphite susceptor (indicated generally at 30) is hung by a quartz hanger 32 from a lift assembly (indicated generally at 34) capable of lowering the susceptor into the bell jar 12 and raising it out of the bell jar. The susceptor 30 has three, vertically arranged recesses (not shown) in each wall, each of which is sized to hold a 150 millimeter semiconductor wafer. It is to be understood that the susceptor 30 may have different numbers of walls and wafer recesses, and being constructed for processing wafers of different sizes while still falling within the scope of the present invention.

The lift assembly 34 includes a cap 36 supporting a sealing plate 37 sealingly engageable with the gas ring 18 for sealing the bell jar chamber, and lift arms 38 connected to the cap for raising and lowering the cap. A purge baffle 40 depends from the cap 36. A drive assembly 42 for rotating the susceptor 30 about its longitudinal axis is located on top of the cap 36. Purge gas lines 46 connected through the cap 36 deliver purge gas generally through the center of the susceptor 30. The construction of the barrel reactor 10, with the exception of the system for delivering reactant and carrier gas to the nozzles 20 as described hereinafter, and the susceptor are well known to the semiconductor material producing industry. Accordingly, only a general description of their features and operation are given herein.

A preferred delivery system 31 for delivering gas from a source of vaporized deposit material and carrier gas (collectively, "gas") is shown in Fig. 1. The gas flows in a primary delivery line 47 from the source through a governor device (not shown, but well known to those of ordinary skill in the art) for maintaining a constant total mass flow rate of gas to the first and second nozzles 20, 21. The primary line 47 separates into a first branch (generally indicated at 47A) which continues on to the first nozzle 20, and a second branch (generally indicated at 47B) which continues on to the second nozzle 21.

The first branch 47A includes a feed line 49 extending from a junction with the primary line 47 to a three way valve 48 operable to selectively divert gas to a first bellows metering valve 50 or a second bellows metering valve 52 piped in parallel with the first bellows metering valve. A terminal line 54 in communication with both of the first and second bellows metering valves 50, 52 transports the gas to the first nozzle 20. The second branch 47B has a similar arrangement, i.e., a feed line 56 extending from the primary line 47 to a three way valve 58 capable of selectively diverting flow to a third bellows metering valve 60 or a fourth bellows metering valve 62 connected in parallel, and a terminal line 64 leading from the third and fourth bellows metering valves to the second nozzle 21. The three way valves 48, 58 and bellows metering valves 50, 52, 60, 62 constitute means for changing the mass flow rates through the first and second nozzles 20, 21 in the piping arrangement shown in Fig. 1.

It is to be understood that other metering devices and piping arrangements for achieving variable flow rates through the first and second nozzles 20, 21 may be used without departing from the scope of the present invention. For instance, one of the pairs of bellows metering valves may be eliminated and replaced with a single bellows metering valve in a line (not shown) extending from the primary line to the first or second nozzle.

Another gas delivery system 31' capable of achieving the objects of the present invention is shown in Fig. 1A to comprise a single bellows metering valve (designated 100, 102, respectively) for each branch 47A, 47B of the delivery system. However, each bellows metering valve 100, 102 has associated with it an automatic adjustment mechanism capable 104 of adjusting the orifice size of that bellows metering valve, and therefore the mass flow rate of gas through the valve and the corresponding nozzle (20 or 21). The automatic adjustment mechanisms 104 are connected to a suitable controller (not shown) which controls their operation. It is also possible to adjust the bellows metering valves 100, 102 manually.

Having described the general construction of the barrel reactor 10, its operation will now be described. The susceptor 30 is loaded with wafers and lowered into the bell jar 12 of the reactor by the lift assembly 34 which simultaneously lowers the seal plate 37 into sealing engagement with the gas ring 18 to seal the interior of the bell jar 12. The environment in the bell jar 12 is purged of oxygen and the heating lamps 26 are activated. The control (not shown) activates the drive assembly 42 to begin rotation of the susceptor in a first direction (clockwise as seen in Fig. 3). Flow of reactant vapor and carrier gas is initiated so that the first and second nozzles 20, 21 emit streams of gas into the bell jar 12. Although the flow of gas injected into the bell jar 12 is complex, it is generally understood that the streams of gas emitted from the first and second nozzles 20, 21 collide, travel down the back side (as seen from the vantage of Fig. 2) of the bell jar wall and then up the front side. Eventually, the gas exits through the exhaust port (not shown) in the bottom of the bell jar 12.

The deposition cycle of the barrel reactor 10 begins as the reactants carried by the carrier gas decompose in the environment of the bell jar 12 and are deposited on the exposed faces of the wafers. The direction of rotation of the susceptor 30 may be reversed during a second half of the deposition cycle, as shown in Fig. 4.

The description of the operation of the barrel reactor 10 thus far is well known to those of ordinary skill in the art. In the prior art, the mass flow rate of gas from the first and second nozzles 20, 21 is substantially constant throughout the entire deposition cycle. In addition, the mass flow rates of gas from each nozzle 20, 21 are approximately the same. In the barrel reactor 10 of the present invention, the mass flow rates of gas from the first and second nozzles 20, 21 are selectively varied during different portions of the deposition cycle. In the preferred embodiment, illustrated in Fig. 3, gas is emitted from the first nozzle 20 at a greater mass flow rate than from the second nozzle 21 during a first portion of the deposition cycle. As shown in Fig. 4, gas is emitted from the first nozzle 20 at a lesser mass flow rate that from the second nozzle 21 during a second portion of the deposition cycle. The mass flow rates are indicated in Figs. 3 and 4 with heavy and light arrows, the heavier arrow indicating the greater mass flow rate.

Referring again to Fig. 1, the change in the mass flow rate of the gas in the gas delivery system 31 is achieved by operation of the three way valves 48, 58 and bellows metering valves (50, 52, 60, 62) of the first and second branches 47A, 47B of the delivery system 31. During the first portion of the deposition cycle, the three way valve 48 of the first branch is set by operation of the control 44 to divert the gas flow through the first bellows metering valve 50 which has been set to permit gas to pass through it at a first rate. At the same time, the control 44 operates the three way valve 58 of the second branch 47B to divert gas through the third bellows metering valve 60 which is set to permit gas to pass through it at a second rate which is substantially less than the first rate.

At the beginning of the second portion of the deposition cycle, the control 44 operates the three way valve 48 of the first branch 47A to divert the flow of gas through the second bellows metering valve 52 so that gas is now emitted from the first nozzle 20 at approximately the same (second) rate at which it was formerly emitted from the second nozzle 21. The three way valve 58 of the second branch 47B is simultaneously activated to divert flow through the fourth bellows metering valve 62 so that gas is now emitted from the second nozzle 21 at approximately the same (first) rate it was formerly emitted from the first nozzle 20. Thus, it may be seen that the mass flow rates of gas through the first and second nozzles 20, 21 is unbalanced by an approximately equal and opposite amount during the first and second portions of the deposition cycle. Although the mass flow rate from the first and second nozzles 20, 21 is changed during the deposition cycle, the total mass flow through the nozzles remains substantially constant throughout the deposition cycle.

It is possible to carry out the method of the present invention employing only a single pair of bellows metering valves (e.g., the first and second bellows metering valves 50, 52 of the first branch 47A). In that case, the second branch would have a single bellows metering valve (not shown) through which gas would pass to the corresponding nozzle throughout the entire deposition cycle. The pair of bellows metering valves 50, 52 on the first branch 47A would be set so that during the mass flow rate of gas through the first nozzle 20 was greater than the mass flow rate through the second nozzle 21 during a first half of the deposition cycle, and less than the mass flow rate through the second nozzle during a second half of the deposition cycle. The difference between the two flow rates is again approximately the same during both halves of the deposition cycle.

In a barrel reactor having the gas delivery system 31' shown in Fig. 1A, the first nozzle 20 is initially supplied with gas at a greater mass flow rate than is supplied to the second nozzle 21. The valve adjusting mechanisms 104 adjust the bellows metering valves 100, 102 to gradually decrease the mass flow rate through the first nozzle 20 and gradually increase the mass flow rate through the second nozzle 21 throughout the deposition cycle. The adjustments can be made continuously, or at intervals during the deposition cycle. Preferably the adjustments are made at the same time, and in equal and opposite amounts.

Rotation of the susceptor 30 is preferably into the flow of gas emitted from the nozzle having the greater mass flow rate during a particular portion of the cycle. The direction of motion of the portion of the susceptor 30 adjacent to the stream of gas emitted from the nozzle at the greater mass flow rate is generally opposite to the direction of flow of gas in the stream. Accordingly, the direction of rotation of the susceptor 30 is reversed by the control 44 at the same time the three way metering valves 48, 58 are activated by the control to change the relative mass flow rates through the first and second nozzles 20, 21.

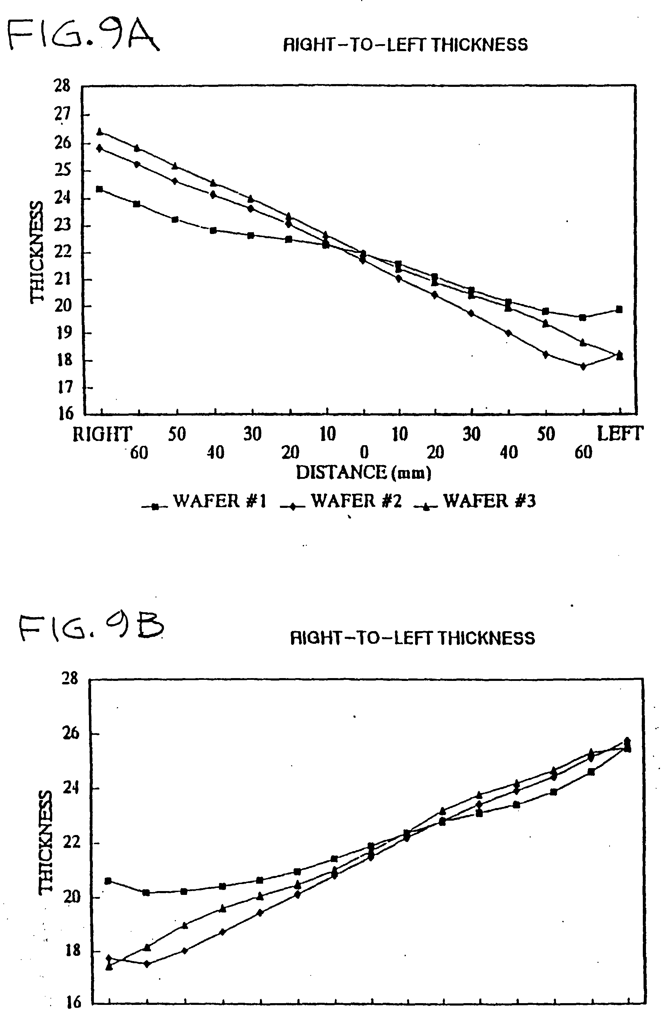

The final thickness of the layer of material deposited on the wafers (Fig. 8) is a composite of the thickness profiles graphically illustrated in Figs. 9A and 9B. Figure 9A illustrates the right to left thickness profile of all three wafers on one wall of the susceptor during the first half of the deposition cycle, and Fig. 9B illustrates the thickness profile during the second half of the cycle. The "right" side and the "left" side of the wafers referred to herein, as well as the top and bottom of the wafers, are the right, left, top and bottom of the wafers as they would be seen on the wall of the susceptor 30 from the vantage indicated by arrow V in Figs. 3 and 4.

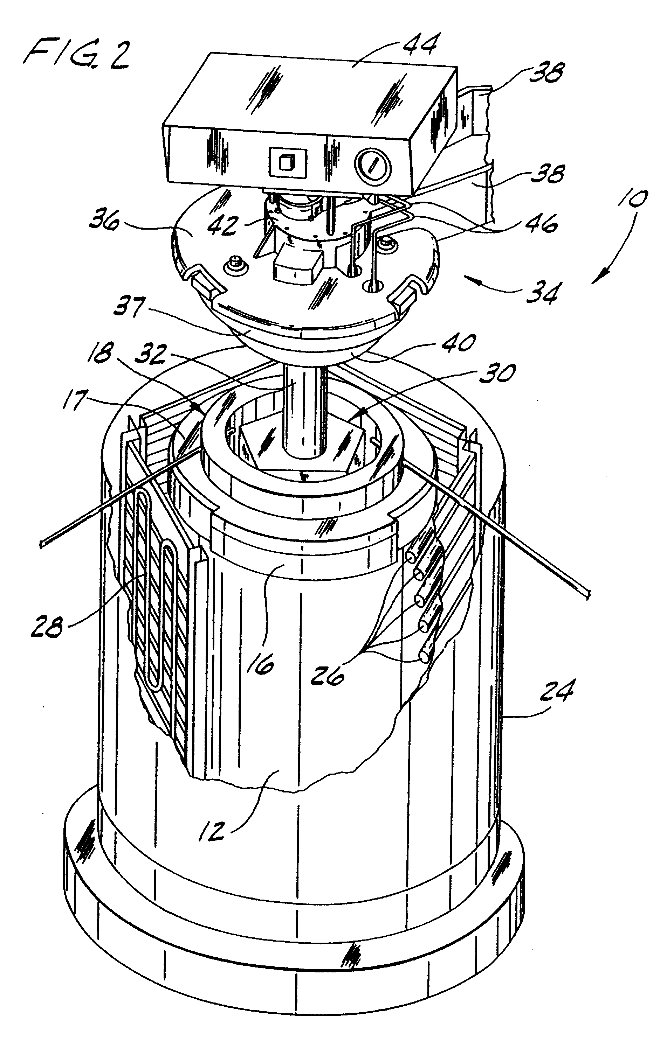

The reference in all of the graphs (Figs. 5-9B) to "wafer #1" refers to the top wafer of the three wafers on one wall of the susceptor 30, the reference to "wafer #2" refers to the middle wafer and the reference to "wafer #3" refers to the bottom wafer. Because of the rotation of the susceptor, the deposition on each wall of the susceptor is essentially the same. Therefore only one wall needs to be characterized. In each of the graphs shown in Figs. 5-9B, the thickness of the wafers has been measured at 10 millimeter intervals from either the top to the bottom of the wafer, or from between left and right sides. The measured thicknesses were normalized by the average center thickness of the three wafers. Thus, the numbers on the ordinate of the graphs are unitless and the numbers on the abscissa are in millimeters, with "0" being the center of the wafers.

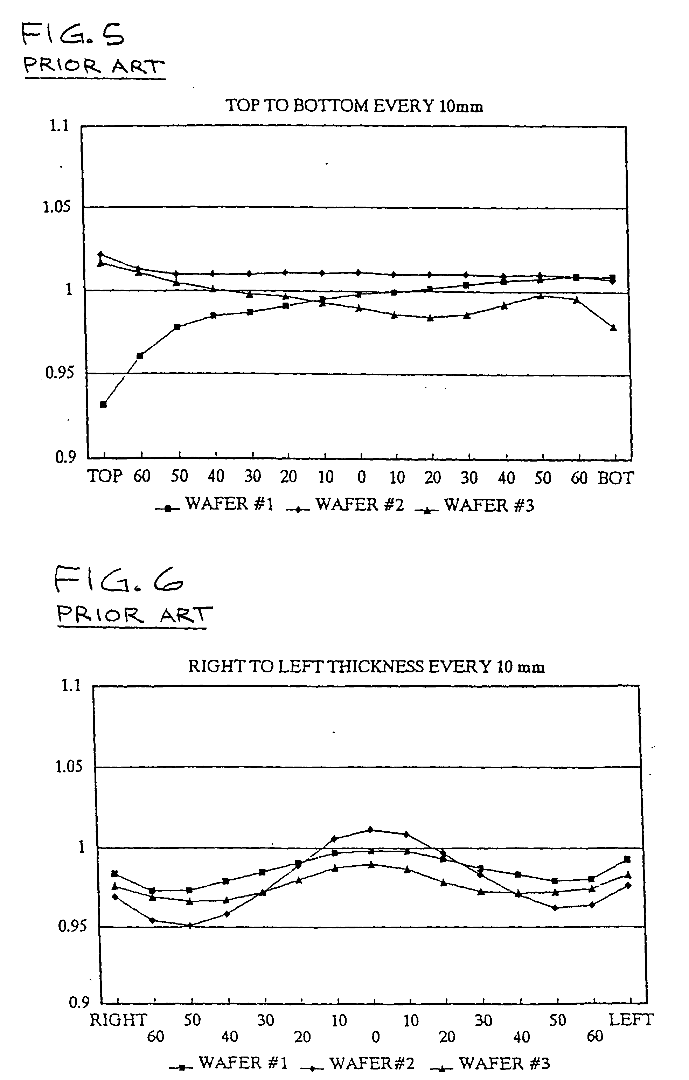

As may be seen in Fig. 9A, the material is deposited to a significantly greater thickness on the right side of the wafers than on the left during the first half of the deposition cycle. The reverse is true during the second half of the deposition cycle (see Fig. 9B). The composite thickness profile, shown in Fig. 8, is flatter than the wavy, W-shaped thickness profile (Fig. 6) of the wafers processed according to the prior art method described above. In other words, more of the measurements are concentrated around a normalized thickness of 1 with the method of the present invention than in the prior art method.

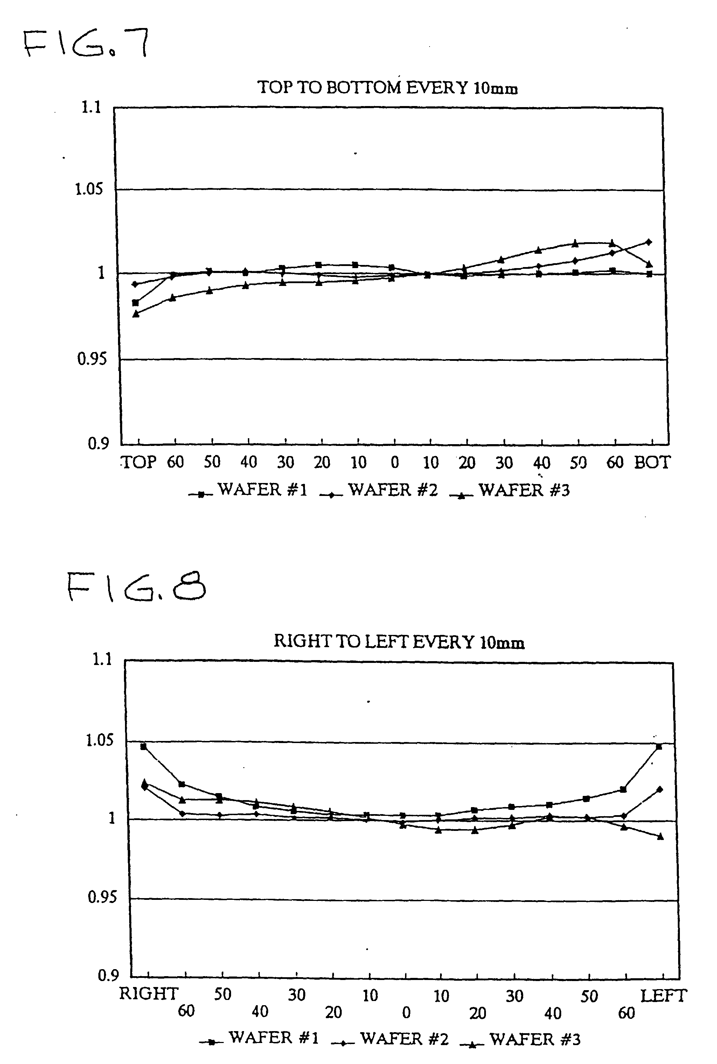

Another important result of the present invention is the improvement in the thickness profile measured at intervals from the top to the bottom of each of the three wafers on one wall of the susceptor 30. The profile for wafers processed according to the existing method is shown in Fig. 5. As may be seen, the thickness of the deposited layer of material drops off dramatically near the top of the top wafer (wafer #1) on the wall. As shown in Fig. 7, the barrel reactor and method of the present invention produces a top to bottom thickness profile which is very flat. In particular, the top wafer (wafer #1) does not exhibit the substantial fall off in thickness found in the prior art.

It is believed that the improvement in top to bottom thickness is caused by the imbalance in mass flow rates from the first and second nozzles 20, 21 during the deposition cycle. The imbalance in mass flow rates imparts a spiral motion to the gas around susceptor 30 after the streams from the two nozzles 20, 21 collide. The horizontal component is believed to permit the gas to reside longer at the top of the susceptor 30, causing more material to be deposited at the top of the top wafer (wafer #1). The greater the imbalance in mass flow rates from the nozzles, the tighter the pitch of the spiral and the longer undecomposed reactant vapor resides near the top of the susceptor 30 in the bell jar 12.

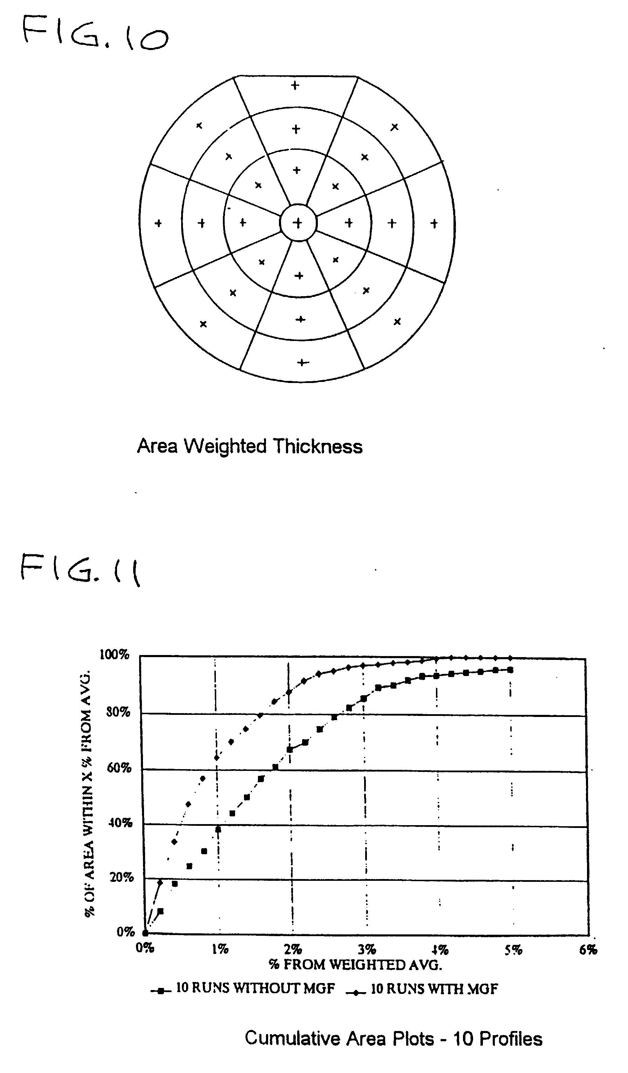

The barrel reactor 10 and method of the present invention also produce overall thickness uniformity superior to the reactors and methods known in the prior art. To illustrate this, measurements of the wafers processed in existing reactors and those processed in the reactor 10 of the present invention were taken at the locations indicated by an "+" in Fig. 10. Ten runs were made using the old process and ten runs using the process of the present invention. In each case, 150 millimeter wafers were used. Twenty-five epitaxial layer thickness measurements were made along eight radii 45° apart around the center of the processed wafers. Measurements were made in the center and at 25 millimeters, 45 millimeters and 65 millimeters from the center, and an area was assigned to each position. The greatest area (5.86% of the wafer face area) is assigned to the radially outermost measurement locations, and the smallest assigned area (1.86%) is at the center measurement location. An area weight cumulative average thickness was calculated for each set of 30 wafers processed corresponding to a respective method.

A cumulative plot of the area thicknesses according to a percent deviation from the area weighted thickness average is shown for both wafers processed according to the present invention and those processed according to the prior art in Fig. 11. The thickness of all of the areas of the wafers processed according to the present invention fall within 4.2% of the area weighted average thickness. In contrast for wafers processed according to prior art methods, only 95% of the areas have a thickness which falls within 5% of the area weighted average. Thus, it may be seen that substantial improvements in overall thickness uniformity are achieved with the apparatus and method of the present invention.

In view of the above, it will be seen that the several objects of the invention are achieved and other advantageous results attained.

As various changes could be made in the above constructions without departing from the scope of the invention, it is intended that all matter contained in the above description or shown in the accompanying drawings shall be interpreted as illustrative and not in a limiting sense.

## Claims

1. A method for chemical vapor deposition of material on a semiconductor wafer (W) held on a susceptor (30) in a reaction chamber of a barrel type chemical vapor deposition reactor (10), the method including the steps of injecting gas composed at least in part of vaporized material to be deposited on the semiconductor wafer from a first nozzle (20) and a second nozzle (21) spaced apart from the first nozzle, and rotating the susceptor about an axis, the steps of injecting gas and rotating the susceptor being carried on during a deposition cycle of the reactor, the method being characterized in that during a first portion of the deposition cycle the first nozzle (20) delivers gas at a greater mass flow rate than the second nozzle (21), and during a second portion of the deposition cycle the second nozzle (21) delivers gas at a greater mass flow rate than the first nozzle (20).

2. A method as claimed in claim 1, characterized in that the susceptor (30) is rotated in a first direction during the first portion of the deposition cycle of the reactor (10), and in a second direction opposite the first during the second portion of the deposition cycle.

3. A method as claimed in claim 2, characterized in that the first direction is generally against the flow of the gas injected from the first nozzle (20) during the first portion of the deposition cycle, and further characterized in that the second direction is generally against the flow of the gas injected from the second nozzle (21) during the second portion of the deposition cycle.

4. A method as claimed in any one of claims 1 to 3, characterized in that the mass flow rate at which gas is delivered from the first nozzle (20) is decreased during the first and second portions of the deposition cycle and the mass flow rate at which gas is delivered from the second nozzle (21) is increased during the first and second portions of the deposition cycle.

5. A method as claimed in claim 4, characterized in that the mass flow rates at which gas is delivered from the first and second nozzles (20, 21) are changed in substantially equal and opposite amounts throughout the deposition cycle.

6. A method as claimed in claim 4 or claim 5, characterized in that the mass flow rate at which gas is delivered from the first nozzle (20) is continuously decreased during the deposition cycle and the mass flow rate at which gas is delivered from the second nozzle (21) is continuously increased during the deposition cycle.

7. A method as claimed in any one of claims 1 to 6, further characterized in that the total mass flow of gas from the first and second nozzles (20, 21) together is maintained substantially constant throughout the deposition cycle.

8. A barrel reactor (10) for use in depositing material on a semiconductor wafer (W), the reactor including a reaction chamber, a susceptor (30) capable of reception in the reaction chamber, the susceptor (30) holding the semiconductor wafer (W) and being mounted for rotation in the reaction chamber about an axis, and a gas delivery system (31, 31') constructed for delivering gas composed at least in part of vaporized material to be deposited on the semiconductor wafer from a source into the reaction chamber, the delivery system (31, 31') comprising a first branch (47A) including a first nozzle (20) disposed for injecting the gas into the reaction chamber, and a second branch (47B) including a second nozzle (21) disposed for injecting gas into the reaction chamber, the barrel reactor (10) being characterized in that at least one of the first and second branches (47A, 47B) includes means for changing the mass flow rate of gas such that the mass flow rate through the first nozzle (20) is greater than the mass flow rate through the second nozzle (21) during a first portion of a deposition cycle, and the mass flow rate through the second nozzle (21) is greater than the mass flow rate through the first nozzle (20) during a second portion of the deposition cycle, said changing means being constructed to change the mass flow rate of the gas without changing the concentration of vaporized deposit material in the gas.

9. A barrel reactor as claimed in claim 8, characterized in that said changing means associated with the first branch (47A) includes a first metering device (50) for metering the flow of gas through the first nozzle (20) at a first flow rate, a second metering device (52) for metering the flow of gas through the first nozzle at a second flow rate, and valve means (48) for placing the first metering device (50) in communication with the source of gas and first nozzle (20) during the first portion of the deposition cycle and for placing the second metering device (52) in communication with the source of gas and first nozzle (20) during the second portion of the deposition cycle.

10. A barrel reactor as claimed in claim 8 or claim 9, characterized in that the changing means associated with the second branch (47B) includes a first metering device (60) for metering the flow of gas through the second nozzle (21) at the first flow rate, a second metering device (62) for metering the flow of gas through the second nozzle (21) at the second flow rate, and valve means (58) for placing the first metering device (60) in communication with the source of gas and second nozzle (21) during the first portion of the deposition cycle and for placing the second metering device (62) in communication with the source of gas and second nozzle (21) during the second portion of the deposition cycle.

11. A barrel reactor as claimed in any one of claims 8 to 10, characterized in that the changing means associated with the first branch (47A) and the changing means (100, 102) associated with the second branch (47B) gradually change the mass flow rates through the first and second nozzles (20, 21) by opposite amounts during the first and second portions of the deposition cycle of the barrel reactor (10).

12. A barrel reactor as claimed in any one of claims 8 to 11, characterized in that said changing means is constructed to provide different constrictions through which the gas including the vaporized deposit material is metered for changing the mass flow rate of the gas.

13. A barrel reactor as claimed in any one of claims 8 to 12, further comprising an automatic control characterized in that the automatic control is configured to control said changing means so that the mass flow rate through the first nozzle (20) is greater than the mass flow rate through the second nozzle (21) during the first portion of the deposition cycle, and the mass flow rate through the second nozzle (21) is greater than the mass flow rate through the first nozzle (20) during the second portion of the deposition cycle.

14. A barrel reactor as claimed in any one of claims 8 to 13, wherein said delivery system (31, 31') is further characterized in that a governor positioned for feeding gas to the first and second branches (47A, 47B) maintains a substantially constant total flow of gas from the first and second nozzles (20, 21) during the deposition cycle.

## Patentansprüche

1. Verfahren zur chemischen Dampfabscheidung von Material auf einer Halbleiterscheibe (W), die auf einem Halter (30) in einer Reaktionskammer eines trommelartigen, chemischen Dampfabscheidungsreaktors (10) gehalten ist, mit den Stufen der Einführung von Gas, das wenigstens zum Teil aus auf der Halbleiterscheibe abzuscheidendem, verdampftem Material besteht, durch eine erste Düse (20) und eine von der ersten Düse auf Abstand gehaltene zweite Düse (21), und Drehung des Halters um eine Achse, wobei die Stufen der Gaseinführung und Halterdrehung während eines Abscheidungszyklus des Reaktors durchgeführt werden, dadurch gekennzeichnet, daß die erste Düse (20) während eines ersten Teils des Abscheidungszyklus Gas mit einer größeren Massenströmungsgeschwindigkeit als die zweite Düse (21) liefert und die zweite Düse (21) während eines zweiten Teils des Abscheidungszyklus Gas mit einer größeren Massenströmungsgeschwindigkeit als die erste Düse (20) liefert.

2. Verfahren nach Anspruch 1, dadurch gekennzeichnet, daß man den Halter (30) während des ersten Teils des Abscheidungszyklus des Reaktors (10) in einer ersten Richtung dreht und während des zweiten Teils des Abscheidungszyklus in einer zu der ersten Richtung entgegengesetzten zweiten Richtung dreht.

3. Verfahren nach Anspruch 2, dadurch gekennzeichnet, daß die erste Richtung im allgemeinen gegen die Strömung des durch die erste Düse (20) während des ersten Teils des Abscheidungszyklus eingeführten Gases gerichtet ist und daß die zweite Richtung im allgemeinen gegen die Strömung des während des zweiten Teils des Abscheidungszyklus durch die zweite Düse (21) eingeführten Gases gerichtet ist.

4. Verfahren nach einem der Ansprüche 1 bis 3, dadurch gekennzeichnet, daß die Massenströmungsgeschwindigkeit, mit der Gas durch die erste Düse (20) geliefert wird, in dem ersten und zweiten Teil des Abscheidungszyklus verringert wird und die Massenströmungsgeschwindigkeit, mit der Gas durch die zweite Düse (21) geliefert wird, in dem ersten und zweiten Teil des Abscheidungszyklus erhöht wird.

5. Verfahren nach Anspruch 4, dadurch gekennzeichnet, daß die Massenströmungsgeschwindigkeiten, mit denen Gas durch die erste und zweite Düse (20,21) geliefert wird, während des Abscheidungszyklus um im wesentlichen gleiche und entgegengesetzte Beträge verändert werden.

6. Verfahren nach Anspruch 4 oder Anspruch 5, dadurch gekennzeichnet, daß die Massenströmungsgeschwindigkeit, mit der Gas durch die erste Düse (20) geliefert wird, während des Abscheidungszyklus kontinuierlich vermindert wird und die Massenströmungsgeschwindigkeit, mit der Gas durch die zweiten Düse (21) geliefert wird, während des Abscheidungszyklus kontinuierlich erhöht wird.

7. Verfahren nach einem der Ansprüche 1 bis 6, ferner dadurch gekennzeichnet, daß man den gesamten Massenstrom des Gases aus der ersten und zweiten Düse (20,21) zusammen während des Abscheidungszyklus im wesentlichen konstant hält.

8. Trommelreaktor (10) für die Abscheidung von Material auf einer Halbleiterscheibe, mit einer Reaktionskammer, einem zur Aufnahme in der Reaktionskammer geeigneten Halter (30), der die Halbleiterscheibe (W) hält und in der Reaktionskammer um eine Achse drehbar angebracht ist, und einem Gaszuführungssystem (31, 31') für die Zuführung von Gas, das wenigstens teilweise aus auf der Halbleiterscheibe abzuscheidendem, verdampftem Material besteht, aus einer Quelle in die Reaktionskammer, wobei das Zuführungssystem (31,31') eine erste Zweigleitung (47A) mit einer ersten Düse (20) zur Gaseinführung in die Reaktionskammer und eine zweite Zweigleitung (47B) mit einer zweiten Düse (21) für die Gaseinführung in die Reaktionskammer umfaßt, und wobei der Trommelreaktor (10) dadurch gekennzeichnet ist, daß wenigstens eine von der ersten und zweiten Zweigleitung (47A,47B) Einrichtungen zur Änderung der Massenströmungsgeschwindigkeit des Gases enthält, so daß die Massenströmungsgeschwindigkeit durch die erste Düse (20) in einem ersten Teil eines Abscheidungszyklus größer als die Massenströmungsgeschwindigkeit durch die zweite Düse (21) ist und die Massenströmungsgeschwindigkeit durch die zweite Düse (21) in einem zweiten Teil des Abscheidungszyklus größer als die Massenströmungsgeschwindigkeit durch die erste Düse (20) ist, wobei die genannte Änderungseinrichtung so konstruiert ist, daß die Massenströmungsgeschwindigkeit des Gases ohne Änderung der Konzentration des verdampften Abscheidungsmaterials in dem Gas geändert wird.

9. Trommelreaktor nach Anspruch 8, dadurch gekennzeichnet, daß die genannte mit der ersten Zweigleitung (47A) verbundene Änderungseinrichtung ein erstes Dosiergerät (50) zur Dosierung der Gasströmung durch die erste Düse (20) bei einer ersten Strömungsgeschwindigkeit und ein zweites Dosiergerät (52) zur Dosierung der Gasströmung durch die erste Düse bei einer zweiten Strömungsgeschwindigkeit und ein Ventil (48) umfaßt, um in dem ersten Teil des Abscheidungssyklus das erste Dosiergerät und im zweiten Teil des Abscheidungszyklus das zweite Dosiergerät mit der Gasquelle und der ersten Düse (20) zu verbinden.

10. Trommelreaktor nach Anspruch 8 oder Anspruch 9, dadurch gekennzeichnet, daß die mit der zweiten Zweigleitung (47B) verbundene Änderungseinrichtung ein erstes Dosiergerät (60) zur Dosierung der Gasströmung durch die zweite Düse (21) bei einer ersten Strömungsgeschwindigkeit und ein zweites Dosiergerät (62) zur Dosierung der Gasströmung durch die zweite Düse (21) bei einer zweiten Strömungsgeschwindigkeit sowie ein Ventil (58) umfaßt, um während des ersten Teils des Abscheidungszyklus das erste Dosiergerät (60) und in dem zweiten Teil des Abscheidungszyklus das zweite Dosiergerät (62) mit der Gasquelle und der zweiten Düse (21) zu verbinden.

11. Trommelreaktor nach einem der Ansprüche 8 bis 10, dadurch gekennzeichnet, daß die mit der ersten Zweigleitung (47A) verbundene Änderungseinrichtung (100) und die mit der zweiten Zweigleitung (47B) verbundene Änderungseinrichtung (102) in dem ersten und zweiten Teil des Abscheidungszyklus des Trommelreaktors (10) die Massenströmungsgeschwindigkeiten der ersten und zweiten Düse (20,21) allmählich um entgegengesetzte Beträge verändern.

12. Trommelreaktor nach einem der Ansprüche 8 bis 11, dadurch gekennzeichnet, daß zur Änderung der Massenströmungsgeschwindigkeit des Gases die genannte Änderungseinrichtung so konstruiert ist, daß unterschiedliche Drosselungen geschaffen werden, durch die das Gas mit dem verdampften Abscheidungsmaterial dosiert wird.

13. Trommelreaktor nach einem der Ansprüche 8 bis 12, ferner mit einer automatischen Regelung, dadurch gekennzeichnet, daß die automatische Regelung die genannte Änderungseinrichtung so regelt, daß die Massenströmungsgeschwindigkeit durch die erste Düse (20) in dem ersten Teil des Abscheidungszyklus größer als die Massenströmungsgeschwindigkeit durch die zweite Düse (21) ist und die Massenströmungsgeschwindigkeit durch die zweite Düse (21) in dem zweiten Teil des Abscheidungszyklus größer als die Massenströmungsgeschwindigkeit durch die erste Düse (20) ist.

14. Trommelreaktor nach einem der Ansprüche 8 bis 13, bei dem das Zuführungssystem (31,31') weiter dadurch gekennzeichnet ist, daß ein Stromregler für die Gasversorgung zu der ersten und zweiten Zweigleitung (47A,47B) während des Abscheidungszyklus einen im wesentlichen konstanten Gesamtgasstrom aus der ersten und zweiten Düse (20,21) aufrechterhält.

## Revendications

1. Procédé de dépôt chimique en phase vapeur d'une matière sur une tranche semi-conductrice (W) supportée par un support actif (30) dans une chambre de réaction d'un réacteur (10) de dépôt chimique en phase vapeur du type à tambour, le procédé comprenant les étapes suivantes : l'injection d'un gaz composé en moins en partie d'une matière vaporisée à déposer sur la tranche semi-conductrice par une première buse (20) et une seconde buse (21) distante de la première buse, et l'entraînement en rotation du support autour d'un axe, les étapes d'injection d'un gaz et d'entraînement en rotation du support étant exécutées pendant un cycle de dépôt du réacteur, le procédé étant caractérisé en ce que, dans une première partie du cycle de dépôt, la première buse (20) distribue un gaz avec un débit massique plus grand que celui de la seconde buse (21), et, dans une seconde partie du cycle de dépôt, la seconde buse (21) distribue du gaz avec un débit massique plus grand que celui de la première buse (20).

2. Procédé selon la revendication 1, caractérisé en ce que le support (30) est entraîné en rotation dans un premier sens pendant la première partie du cycle de dépôt du réacteur (10), et dans un second sens opposé au premier pendant la seconde partie du cycle de dépôt.

3. Procédé selon la revendication 2, caractérisé en ce que le premier sens est opposé de façon générale à la circulation du gaz injecté par la première buse (20) pendant la première partie du cycle de dépôt, et caractérisé en outre en ce que le second sens est opposé de façon générale au courant du gaz injecté par la seconde buse (21) pendant la seconde partie du cycle de dépôt.

4. Procédé selon l'une des revendications 1 à 3, caractérisé en ce que le débit massique avec lequel le gaz est distribué par la première buse (20) est réduit pendant la première et la seconde partie du cycle de dépôt et le débit massique avec lequel le gaz est distribué par la seconde buse (21) est augmenté pendant la première et la seconde partie du cycle de dépôt.

5. Procédé selon la revendication 4, caractérisé en ce que les débits massiques avec lesquels le gaz est distribué par la première et la seconde buse (20, 21) sont modifiés en quantités pratiquement égales et opposées au cours du cycle de dépôt.

6. Procédé selon la revendication 4 ou 5, caractérisé en ce que le débit massique avec lequel le gaz est distribué par la première buse (20) est réduit de façon continue pendant le cycle de dépôt et le débit massique avec lequel le gaz est distribué par la seconde buse (21) est augmenté de façon continue pendant le cycle de dépôt.

7. Procédé selon l'une quelconque des revendications 1 à 6, caractérisé en outre en ce que le débit massique total du gaz provenant de la première et de la seconde buse (20, 21) considérées ensemble est maintenu à une valeur pratiquement constante pendant tout le cycle de dépôt.

8. Réacteur à tambour (10) destiné à être utilisé pour le dépôt d'une matière sur une tranche semi-conductrice (W), le réacteur comprenant une chambre de réaction, un support actif (30) qui peut se loger dans la chambre de réaction, le support (30) supportant la tranche semi-conductrice (W) et étant monté afin qu'il tourne dans la chambre de réaction autour d'un axe, et un système (31, 31') de distribution de gaz ayant une construction telle qu'il peut distribuer un gaz composé en moins en partie d'une matière vaporisée à déposer sur la tranche semi-conductrice provenant d'une source dans la chambre de réaction, le système de distribution (31, 31') comprenant une première dérivation (47A) qui comporte une première buse (20) disposée afin qu'elle injecte le gaz dans la chambre de réaction, et une seconde dérivation (47B) qui comprend une seconde buse (21) disposée afin qu'elle injecte du gaz dans la chambre de réaction, le réacteur à tambour (10) étant caractérisé en ce que l'une au moins des première et seconde dérivations (47A, 47B) comprend un dispositif destiné à changer le débit massique du gaz afin que le débit massique de la première buse (20) soit supérieur au débit massique de la seconde buse (21) dans une première partie d'un cycle de dépôt, et que le débit massique de la seconde buse (21) soit supérieur au débit massique de la première buse (20) pendant une seconde partie du cycle de dépôt, le dispositif de changement ayant une construction telle qu'il change le débit massique du gaz sans changer la concentration de la matière vaporisée de dépôt dans le gaz.

9. Réacteur à tambour selon la revendication 8, caractérisé en ce que le dispositif de changement associé à la première dérivation (47A) comprend un premier dispositif de dosage (50) destiné à doser le débit de gaz dans la première buse (20) à un premier débit, un second dispositif (52) de dosage destiné à doser le débit de gaz dans la première buse à un second débit, et un dispositif à soupape (48) destiné à placer le premier dispositif de dosage (50) en communication avec la source de gaz et la première buse (20) pendant la première partie du cycle de dépôt et à placer le second dispositif de dosage (52) en communication avec la source de gaz et la première buse (20) pendant la seconde partie du cycle de dépôt.

10. Réacteur à tambour selon la revendication 8 ou 9, caractérisé en ce que le dispositif de changement associé à la seconde dérivation (47B) comporte un premier dispositif de dosage (60) destiné à doser le débit de gaz dans la seconde buse (21) au premier débit, un second dispositif de dosage (62) destiné à doser le débit de gaz dans la seconde buse (21) au second débit, et un dispositif à soupape (58) destiné à placer le premier dispositif de dosage (60) en communication avec la source de gaz et la seconde buse (21) au cours de la première partie du cycle de dépôt et à placer le second dispositif de dosage (62) en communication avec la source de gaz et la seconde buse (21) pendant la seconde partie du cycle de dépôt.

11. Réacteur à tambour selon l'une quelconque des revendications 8 à 10, caractérisé en ce que le dispositif de changement associé à la première dérivation (47A) et le dispositif de changement (100, 102) associé à la seconde dérivation (47B) modifient progressivement les débits massiques dans la première et la seconde buse (20, 21) en quantités opposées pendant la première et la seconde partie du cycle de dépôt du réacteur à tambour (10).

12. Réacteur à tambour selon l'une quelconque des revendications 8 à 11, caractérisé en ce que le dispositif de changement a une construction telle qu'il donne des rétrécissements différents par lesquels le gaz contenant la matière vaporisée de dépôt est dosé pour le changement du débit massique du gaz.

13. Réacteur à tambour selon l'une quelconque des revendications 8 à 12, comprenant en outre une commande automatique caractérisé en ce que la commande automatique a une configuration telle qu'elle commande le dispositif de changement afin que le débit massique dans la première buse (20) soit supérieur au débit massique dans la seconde buse (21) pendant la première partie du cycle de dépôt, et que le débit massique dans la seconde buse (21) soit supérieur au débit massique dans la première buse (20) pendant la seconde partie du cycle de dépôt.

14. Réacteur à tambour selon l'une quelconque des revendications 8 à 13, dans lequel le système de distribution (31, 31') est en outre caractérisé en ce qu'un organe de contrôle destiné à transmettre du gaz à la première et à la seconde dérivation (47A, 47B) maintient un débit total pratiquement constant de gaz dans la première et la seconde buse (20, 21) pendant le cycle de dépôt.
